# EUROPÄISCHE PATENTSCHRIFT

(11) **EP 0 875 086 B1**
(45) Veröffentlichungstag und Bekanntmachung des Hinweises auf die Patenterteilung: **10.05.2000**
(21) Anmeldenummer: 96944626.9
(22) Anmeldetag: 20.12.1996
(51) Int. Cl.: H02B 1/56, H05K 7/20

(54) **KLIMATISIERTER SCHALTSCHRANK**
AIR-CONDITIONED SWITCHING CABINET
ARMOIRE DE DISTRIBUTION CLIMATISEE

(30) Priorität: 17.01.1996 DE 19601456
(43) Veröffentlichungstag der Anmeldung: 04.11.1998
(73) Patentinhaber: Rittal-Werk Rudolf Loh GmbH & Co. KG, 35745 Herborn (DE)
(72) Erfinder: MÜLLER, Norbert, D-35716 Dietzhölztal (DE)
(74) Vertreter: Fleck, Hermann-Josef, Dr.-Ing.
(86) Internationale Anmeldenummer: EP9605789
(87) Internationale Veröffentlichungsnummer: WO9726691

(56) Entgegenhaltungen:
- DE-A- 3 717 540
- DE-A- 4 013 372
- US-A- 4 535 386
- SIEMENS POWER ENGINEERING PRODUCT NEWS, Bd. 4, Nr. 4, Dezember 1984, PASSAU , Seiten 19-20, XP002029254 BRIGITTE AUGNER: "New 8ME78 Heat Exchangers"

## Beschreibung

Die Erfindung betrifft einen klimatisierten Schaltschrank mit Wandelementen und mindestens einer Schranktüre sowie einem Klimagerät, wobei das Klimagerät in die Schranktüre integriert ist.

Ein solcher Schaltschrank ist aus dem Dokument US 4,535,386 bekannt. In dieser Druckschrift ist ein Schaltschrank beschrieben, der mittels einer Schranktüre verschlossen werden kann. Auf der Innenseite der Schranktüre ist ein Wärmetauscher vorhanden. Im Inneren des Schaltschrankes lassen sich auf dem Boden elektrische Einbauten montieren. Die von diesen elektrischen Einbauten abgegebene warme Luft gelangt in den Wärmetauscher und steigt hier in dafür vorgesehenen Kanälen nach oben. Dabei tauscht sie ihre Wärme über die Außenwandung der Schranktüre in die Umgebung ab. Nach dem Durchtritt durch den Wärmetauscher wird die gekühlte Luft wieder zurück in den Innenraum des Schaltschrankes geführt. Solche Wärmetauscher lassen sich nur bei Schaltschränken einsetzen, bei denen eine geringe Wärmemenge im Betrieb entwickelt wird. Soll im Innenraum des Schaltschrankes eine hoch-leistungsfähige Elektronik installiert werden, dann muß ein zusätzliches Klimagerät angebaut werden. Hierzu wird in der Regel an einer der Seitenwände des Schaltschrankes ein Klimagerät angebaut. Um Zugang zum Innenraum des Schaltschrankes zu erhalten, wird die Seitenwand mit entsprechenden Durchbrüchen versehen.

In der DE 37 17 540 A1 ist eine solche Anordnung beispielhaft dargestellt. Dabei ist das Klimagerät auf der Außenseite der Schranktüre montiert. Damit kein Schmutz aus der Umgebung in den Innneraum des Schaltschrankes gelangen kann, müssen die Durchbrüche in der Schranktüre sorgfältig nachträglich abgedichtet werden.

Es ist Aufgabe der Erfindung, einen Schaltschrank zu schaffen, bei dem zur effektiven Kühlung des Innenraumes die nachträgliche Aufrüstung eines Klimagerätes ohne größeren Aufwand möglich ist.

Diese Aufgabe der Erfindung wird mit den Merkmalen des Patentanspruches 1 gelöst. Demgemäß ist es vorgesehen, daß die Schranktüre als wannenförmiges Gehäuse zur Aufnahme der Komponenten des Klimagerätes ausgebildet ist. Infolge der wannenförmigen Ausgestaltung lassen sich die Komponenten des Klimagerätes so unterbringen, daß der Innenraum des Schaltschrankes nicht beeinträchtigt wird. Das wannenförmige Gehäuse begrenzt somit einen Aufnahmeraum, der sich an den Innenraum des Rahmengestelles oder des Schrankkorpusses anschließt. Infolge dieser Maßnahme entfällt die Notwendigkeit, nachträglich Öffnungen im Schaltschrankkorpus vorzusehen, um den Zugang der klimatisierten Luft zum Innenraum des Schaltschrankes zu ermöglichen. In dem wannenförmigen Gehäuse sind die Komponenten des Klimagerätes betriebsbereit miteinander verbunden und verkabelt. Zur nachträglichen Aufrüstung eines Schaltschrankes mit einer effektiven Klimatisierungsanlage muß lediglich die erfindungsgemäße Tür angebaut werden. Die ist ohne großen Aufwand möglich.

Die Luftzirkulation im Schaltschrank kann dadurch gezielt beeinflußt werden, daß die Komponenten des Klimagerätes zum Innenraum des Schrankkorpus des Rahmengestelles hin mittels einer Abdeckung abgedeckt sind und die Abdeckung mit Luft-Ausgangsöffnungen und Luft-Austrittsöffnungen versehen ist.

Die Erfindung wird anhand von in den Zeichnungen schematisch dargestellten Ausführungsbeispielen näher erläutert. Es zeigen:
- Fig. 1: schematisch einen geöffneten Schaltschrank mit Rahmengestell, bei dem in ein Wandelement ein Klimagerät integriert ist, und
- Fig. 2: schematisch einen geöffneten Schaltschrank mit Schrankkorpus, bei dem in die Schranktüre ein Klimagerät integriert ist.

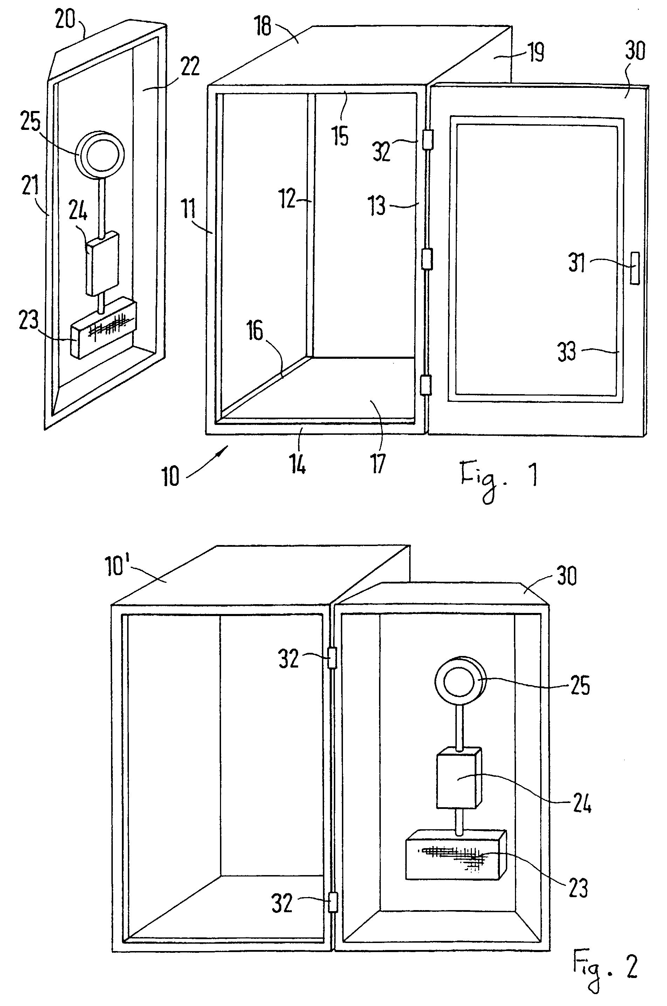

Die Fig. 1 zeigt einen Schaltschrank mit einem Rahmengestell 10, das mittels eines Bodenbleches 17, eines Deckbleches 18 und eines Wandelementes 19 an drei Seiten verschlossen ist.

Die linke Seite des Rahmengestelles 10, die durch vertikale Rahmenschenkel 11 und 12 und horizontale Rahmenschenkel 16 begrenzt ist, wird mit einem Wandelement 20 verschlossen, in das ein Klimagerät mit den Komponenten 23, 24 und 25 integriert ist. Die durch die Rahmenschenkel 11, 13, 14 und 15 begrenzte Vorderseite des Rahmengestelles 10 wird mittels einer Schranktüre 30 verschlossen. Die Schranktüre 30 ist mittels Scharnieren 32 an vertikalen Rahmenschenkel 13 angelenkt und kann mittels eines Verschlusses 31 in der Schließstellung festgelegt werden. Auf der Innenseite kann die Schranktüre 30 mittels eines aufgesetzten Türrahmens 33 versteift sein.

Das im Querschnitt trapezförmige Wandelement 20 mit den geneigten Wandteilen 21 und 22 bildet ein wannenartiges Gehäuse, in das die Komponenten 23, 24 und 25 des Klimagerätes eingebaut sind, so daß eine integrierte Baueinheit entsteht, die wie ein normales Wandelement 19 mit dem Rahmengestell 10 verbunden werden kann.

Die Komponenten 23, 24 und 25 können im Wandelement 20 mittels einer Abdeckung abgedeckt werden, die mit Luf-Ausgangs- und Luft-Austrittsöffnungen versehen ist. Dabei können sich unmittelbar dahinter die ausreichend ausgebildeten Komponenten des Klimagerätes anschließen.

Anstelle eines Rahmengestelles 10 und der Wandelemente kann auch ein Schrankkorpus 10 verwendet werden, der nur an seiner Vorderseite offen ist, wie Fig. 2 zeigt. Dann ist die Schranktüre 30 als Gehäuse für die Komponenten 23, 24 und 25 des Klimagerätes. Die Schranktüre 30 mit integriertem Klimagerät wird dann wie eine normale Schranktüre am Schrankkorpus angelenkt. Im Regelfall wird der klimatisierte Schaltschrank mit in die Schranktüre 30 integriertem Klimagerät als Liefereinheit bereitgestellt und kann mit betriebsbereit verbundenen und verdrahteten Komponenten bezogen werden. Die Schranktüre mit integriertem Klimagerät kann jedoch auch als Baueinheit nachbestellt und für die nachträgliche Klimatisierung eines vollständig ausgebauten und bestücken Schaltschrankes verwendet werden. Dabei braucht nur die Schranktüre ausgetauscht zu werden.

## Patentansprüche

1. Klimatisierter Schaltschrank mit Wandelementen und mindestens einer Schranktüre sowie einem Klimagerät, wobei das Klimagerät in die Schranktüre integriert ist,
dadurch gekennzeichnet,
daß die Schranktüre (30) als wannenförmiges Gehäuse zur Aufnahme der Komponenten (23, 24, 25) des Klimagerätes ausgebildet ist, und einen Aufnahmeraum begrenzt, der sich an den Innenraum des Rahmengestelles (10) oder des Schrankkorpus anschließt und in dem die Komponenten (23, 24, 25) des Klimagerätes betriebsbereit miteinander verbunden und verdrahtet sind.

2. Klimatisierter Schaltschrank nach Anspruch 1,
dadurch gekennzeichnet,
daß die Komponenten (23, 24, 25) des Klimagerätes zum Innenraum des Schrankkorpus des Rahmengestelles hin mittels einer Abdeckung abgedeckt sind.

3. Klimatisierter Schaltschrank nach Anspruch 1 oder 2,
dadurch gekennzeichnet,
daß die Abdeckung mit Luft-Ansaugöffnungen und Luft-Austrittsöffnungen versehen ist.

## Claims

1. Air-conditioned switchgear cabinet with wall elements and at least one cabinet door (10), as well as an air-conditioning appliance, the air-conditioning appliance being incorporated in the cabinet door, characterised in that the cabinet door (30) is configured as a trough-like housing for accommodating the components (23, 24, 25) of the air-conditioning appliance and defining a receiving chamber, which communicates with the interior of the framework (10) or of the cabinet body, and in which chamber the components (23, 24, 25) of the air-conditioning appliance are interconnected and wired ready for operation.

2. Air-conditioned switchgear cabinet according to claim 1, characterised in that the components (23, 24, 25) of the air-conditioning appliance are covered by means of a covering towards the interior of the cabinet body of the framework.

3. Air-conditioned switchgear cabinet according to claim 1 or 2, characterised in that the covering is provided with air inlet apertures and air outlet apertures.

## Revendications

1. Armoire de distribution climatisée avec des éléments de paroi et avec au moins une porte d'armoire ainsi qu'avec un appareil de climatisation, où l'appareil de climatisation est intégrée dans la porte de l'armoire,
caractérisée
en ce que la porte d'armoire (30) a la forme d'un boîtier en forme de cuve pour le logement des composants (23, 24, 25) de l'appareil de climatisation et délimite une chambre de logement, qui se raccorde à l'enceinte intérieure de l'ossature d'encadrement (10) ou du corps de l'armoire et dans laquelle les composants (23, 24, 25) de l'appareil de climatisation sont assemblés et câblés prêts au service.

2. Armoire de distribution climatisée suivant la revendication 1,
caractérisée
en ce que les composants (23, 24, 25) de l'appareil de climatisation sont séparés de l'enceinte intérieure du corps de l'armoire au moyen d'un recouvrement.

3. Armoire de distribution climatisée suivant la revendication 1 ou la revendication 2,
caractérisée
en ce que le recouvrement présente des ouvertures d'admission d'air et des ouvertures d'échappement d'air.
